# EUROPEAN PATENT SPECIFICATION

(11) **EP 1 804 200 B1**
(45) Date of publication and mention of the grant of the patent: **08.04.2009**
(21) Application number: 05028724.2
(22) Date of filing: 30.12.2005
(51) Int. Cl.: G06K 19/077

(54) **IC card with improved printed circuit**
IC Karte mit verbesserter Leiterplatine
Carte à puce avec circuit imprimé amélioré

(43) Date of publication of application: 04.07.2007
(73) Proprietor: Incard SA, 1204 Geneva (CH)
(72) Inventor: Frallicciardi, Paolo, 84100 Salerno (IT); Visconti, Edoardo, 80034 Marigliano (Napoli) (IT)
(74) Representative: Botti, Mario

(56) References cited:
- DE-A1- 10 101 280
- DE-A1- 19 826 428
- FR-A- 2 634 095
- US-A- 5 598 032
- US-A- 5 834 755
- US-A- 6 076 737
- US-A1- 2003 016 507

## Description

### Filed of application

The present invention relates to an IC Card comprising
- a plastic support with a recess,
- an integrated circuit chip hosted in said recess,
- a plated module including a printed circuit comprising a plurality of conductive areas, delimited by a network of insulating channels, for covering said integrated circuit chip, at least some of said conductive areas being connected to a corresponding contact point of said integrated circuit chip.

### Prior Art

As is well known an IC Card generally comprises a plastic support with a recess, an integrated circuit chip and a printed circuit, being the printed circuit wire bonded on the integrated circuit chip and glued inside the recess through an epoxy resin.

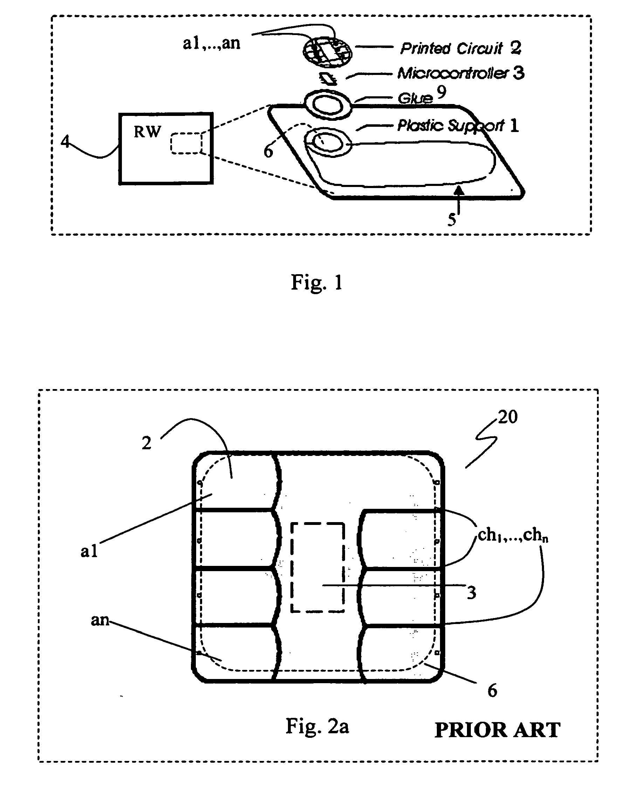

With reference to figure 1, an IC Card 10 is represented in an exploded view, being the plastic support indicated with numeral reference 1, the recess with 6, the printed circuit and the integrated circuit chip respectively with 2 and 3.

More particularly, the printed circuit 2 comprises a plurality of conductive areas a1,.., an, glued through stripes of epoxy resin 9.

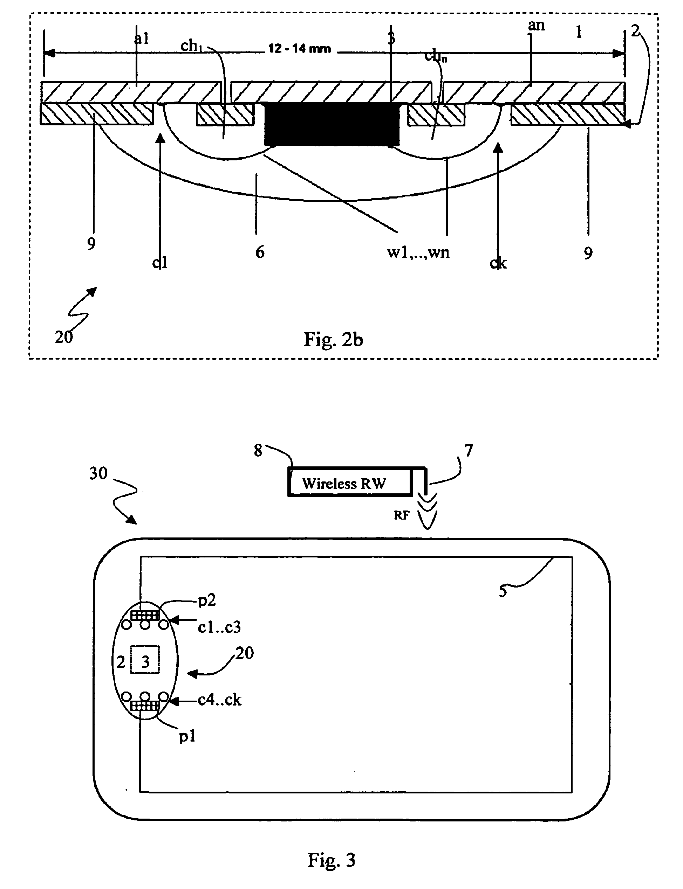

The integrated circuit chip 3 is fixed and electrically connected through wires bonding beneath the printed circuit 2, and than sealed in the recess 6. Said electrical connections are clearly shown in figure 2a and 2b, representing respectively a top view of the printed circuit 2, sealed inside the recess 6 with the integrated circuit chip 3 beneath, and the corresponding lateral cross section.

Some or all of said conductive areas al,.., ak (if all, n=k) are connected through a corresponding plurality of bonding wires wl,..,wj to said integrated circuit chip 3 in a plurality of contact points cl,..,ck. These contact points cl,..,ck provides communication connection between an external read write device 4 and the integrated circuit chip 3.

More particularly, the communication between a wireless external read and write device 8 and the IC Card 10 is contactless when the IC Card 10 is provided with an antenna 5, laying inside the plastic support 1 and connected to said contact points c1..ck through a couple of pad p1, p2 as schematically shown in figure 3.

The antenna 5 sends and receives electromagnetic waves to and from a coupling antenna 7, included in the wireless external read write device 8, being the integrated circuit chip 3 powered by electromagnetic induction from the wireless external read write device 8.

Generally, when the IC Card 10 is able to communicate both in contact and in contactless mode is defined combined or comby IC Card 10.

The IC Card 10 takes its intelligence from the integrated circuit chip 3 that is integrated by silicon technology and is easy to break. As is well known, those cards are widely used for many purposes, for instance: providing credit cards, telephone cards, smart cards, pre-paid access cards; ID cards; badge pass; etc.

According to the different application fields, those cards may be kept by the user in wallets or, envelopes that might be protective subject to bending or stressing forces on the IC card itself.

Therefore, in order to avoid breakage when the IC Card 10 is bent, the integrated circuit chip 3 is restricted to only a few millimeters in size and is protected through the printed circuit 2 from physical pressures and static electricity.

More particularly, to hold the integrated circuit chip 3 assembled with the printed circuit 2, the recess 6 is milled into the plastic support 1 using CNC machines with multiple drill bits, the dimension and location of the recess 6 being carefully controlled to meet with ISO standards.

Nevertheless, being the IC Card usually kept by hand and hidden in wallets, it undergoes to usury and solicitation damages and stress mainly with respect to the printed circuit 2 and the integrated circuit chip 3, especially around the recess 6 wherein the IC circuit lies.

IC cards with a printed circuit and an integrated circuit chip are known e.g. from US-A-5 834 755.

More particularly, when the IC Card 10 is plated, deformed or stressed, all the solicitations act in proximity to the external circumference of the recess 6, sometimes causing the partial detaching of the integrated circuit chip 3 from the plastic support 1 or a bending of the module producing a detaching between a conductive area and a contact point.

Even if these solicitations don't cause said detaching, the contact points cl..ck may be damaged, causing the communication between the integrated circuit chip 3 and the external read write device 4 to fail.

Also the communication with the wireless external read write device 8 may be damaged, due to solicitations on the antenna 5, especially on pads p1 and p2 that are located near the external circumference of the printed circuit 2.

The problem underlying the present invention is to provide a IC Card resistant to solicitations due to plating or deforming the plastic support of the IC Card, especially reducing the effect of these solicitations in proximity of the recess of the plastic support in which the printed circuit and the integrated circuit chip are inserted and fixed, safeguarding the contact points for using the IC Card and protecting the connection between the pads and the antenna.

### Summary of the invention

The solution idea on which the invention is based is that of enlarging the surface of the conductive areas of the IC card plated module providing extended areas linked to at least some of said conductive areas by a bridge.

This problem is solved, according to the present invention, by an IC Card as previously indicated and defined by the characterising portion of the enclosed claim 1.

The features and advantages of the invention will be apparent from the following description of an embodiment thereof, given by way of non-limitative example with reference to the accompanying drawings.

### Brief description of the drawings

- Figure 1 schematically represents, in a perspective exploded view, an IC Card comprising a plated module realised according to the prior art.
- Figure 2a schematically represents, in a top view, the plated module of figure 1 realised according to the prior art.
- Figure 2b schematically represents a lateral view of figure 2a.
- Figure 3 schematically represents the connection between a plated module and an antenna, according to the prior art.
- Figure 4 schematically represents, in a top view, an IC card provided with a plated module realised according to the present invention.
- Figure 5 schematically represents, in major details the plated module of figure 4.

### Detailed description

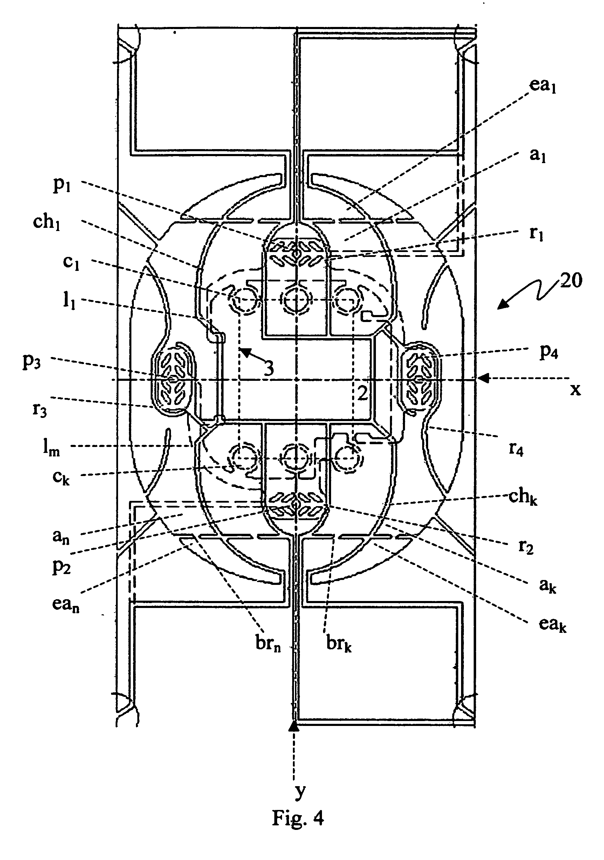

With reference to figure 4 is shown and is globally indicated with 30 an IC card comprising a plastic support 1 and a plated module 20, glued inside a recess 6 not explicitly shown because conventional.

The plated module 20 includes a printed circuit 2, comprising a plurality of conductive areas a₁,..,aₙ delimited by a network of insulating channels ch₁,..,chₙ covering an integrated circuit chip 3.

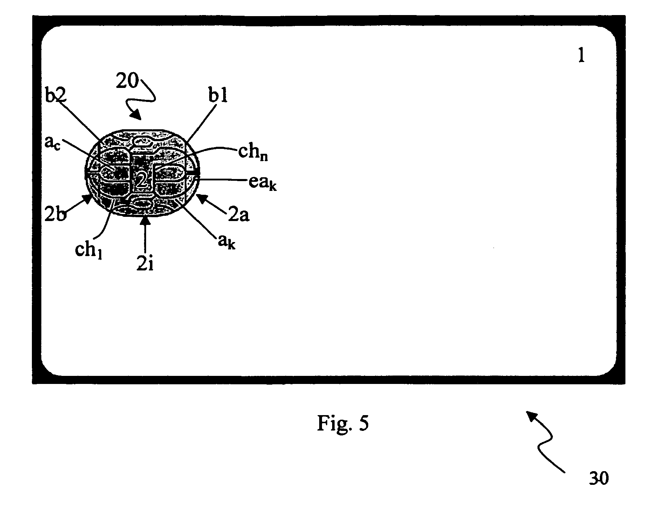

More particularly, as shown in figure 5, at least some of the conductive areas a₁,..,aₙ are connected through wire bonding w₁,..,wₖ to a corresponding contact point c₁,..,cₖ on the integrated circuit chip 3, so to provided communication connection between an external read write device 4 and the integrated circuit chip 3.

According to the present invention, a plurality extended areas ea₁,..,eaₘ at the border of the recess 6 are linked to at least some of the conductive areas a₁,..,aₙ through one or more bridge br₁,.., brₙ.

An extended area ea₁,..,eaₘ is delimited from a nearby extended area ea₁,..,eaₘ or from a corresponding conductive area a₁,..,aₙ, na₁,..,naₙ by an additional insulating channel chₖ₊₁.

More particularly, the extended areas ea₁,..., eaₖ are formed by the same material used for the corresponding conductive areas a₁,..,aₙ. Also the bridge br₁,.., brₙ may be constituted by the same material used for the conductive areas a₁,..,aₙ, na₁,..,naₙ.

The insulating channels ch₁,..,chₖ surround the conductive areas a₁,..,aₙ, associated to conductive areas a₁,..., aₙ which are linked with contact points c₁,..., cₖ as a frame, so to protect the connection between the corresponding contact point c₁,..,cₖ.

More particularly, an insulating channel b₁, divides the conductive areas a₁,..,aₙ from the nearby extended areas ea₁,..,eaₘ, being the insulating channel b1 crossed by a plurality of bridges br₁,.., brₙ.

The insulating channel b1 and the bridges br₁,.., brₙ act as a mechanical bypass between an internal part 2i, including the conductive areas a₁,..,aₙ, na₁,..,naₙ, and a border part 2a, 2b, including the extended areas ea₁,..,eaₘ; the mechanical bypass is intended to absorb solicitation on said internal part 2i.

The plated module 20 has a rounded border formed by, at least, a couple of advanced extended areas. The advanced extended areas forming the round border of said plated module 20 are linked to corresponding conductive area being, these last, advantageously not associated to the integrated circuit chip with corresponding contact points c₁,..., cₖ.

The advanced extended areas Adv₁,..., Advₙ forming the round border, circle or wrap around those extended areas ea₁,..., eaₙ, which are associated to conductive areas a₁,..., aₙ linked with contact points c₁,..., cₖ.

In this way, the solicitations acting on the border of the recess 6 are distributed especially on extended area ea₁,.... eaₙ that are passive respect the functioning of the integrated circuit 3.

The advanced extended areas and the extended areas ea₁,..., eaₙ are separated by the conductive areas a₁,..., aₙ through an alignment of insulating channels that look like a weakening line represented by the insulating channel b1 or b2 crossed by the plurality of bridges br₁,.., brₙ.

More particularly, both the border of the plated module 20 is rounded by correspondent couple of advanced extended areas.

The conductive area a₁,..., aₙ has at least a major side curved; also a minor side of the conductive area a₁,..., aₙ may be curved, to round and protect the connection with the corresponding contact point c₁,..,cₖ wire bonded. More particularly, at least one central conductive area a_{c} has a semi-circumferential side.

In case of contactless communication an external read-write device 8 is connected to the integrated circuit chip 3, the antenna 5 laying inside the plastic support 1 being connected to said contact points c₁,..,cⱼ through a couple of pads p₁, p₂ in a standard way.

Advantageously, said pads p₁, p₂ are inside the internal part 2i of the plated module 20, being the solicitations acting on the border of the recess 6, and generally on the plated module 1, absorbed by the extended area ea₁,..., eaₙ, in favour of the pads p1, p2.

More particularly, a plurality of redundancy pads p₃, p₄, advantageously inside the internal part 2i, are used to connect the antenna 5 and the contact points c₁,..,cⱼ. In this way, a supplying of power from the antenna 5 to the contact points c₁,..,cⱼ is guaranteed also when some or both said pads p₁, p₂ are broken.

More particularly, a plurality of insulating channels r1, r2, r3, r4 protect said pads p1, p2, p3, p4.

According to the present invention, the recess 6 is milled in a location of the plastic support 1 less exposed to solicitations. As instance, considering an x axis as a major axis of a major surface of the IC Card and an y axis as a minor axis of the same surface, the recess 6 is decentered respect the x and/or the y axis. For example the recess 6 may be included inside a quadrant q of the plastic support 1, being the quadrant q delimited by the major and minor axis x, y.

According to another embodiment of the present invention, the extended areas ea₁,..., eaₙ are not constituted of the same material used for the corresponding conductive area a₁,..., aₙ.

As instance, the extended areas ea₁,..., eaₙ are constituted by epoxy resin 9 filling the external parts 2a, 2b and absorbing solicitations acting on the border of the plated module 30. Moreover, the epoxy resin 9, distributed on the external parts 2a, 2b, increases the adherence of the conductive areas a₁, aₙ on the internal part 2i.

According to another embodiment of the present invention, the extended areas ea₁,..., eaₙ are formed by a material different from epoxy resin for example an insulating or conductive material easy coupling with the recess 6 and tough to solicitations and pressures.

Advantageously, the IC card according to the present invention is resistant to solicitations due to plating or deforming, especially reducing the effect of these solicitations in proximity of the recess 6 of the plastic support 1 wherein the printed circuit 2 and the integrated circuit chip 3 resides.

The plurality of extended areas of the plated module 20 in fact, absorb solicitations near the border of recess 6 and protects the contact points c1..ck that connects the conductive areas a1,..,an of the printed circuit 1 to the respective bonding wires w1,..,wn.

A possible break of an extended area ea₁,..., eaₙ, its detachment from the recess 6 or a dissociation with a corresponding conductive area does not cause the in utilization of the IC card while in case of contactless communication the break of the pads p1, p2 are solved by the redundancy pads p3, p4.

The concentric disposition of the advanced extended areas ea₁,..., eaₙ as a protection of the extended areas ea₁,..., eaₙ linked to conductive areas directly associated to the integrated circuit chip 3 or to the corresponding pads p1, p2, p3, p4, preserve the functioning of the integrated circuit chip 3.

## Claims

1. IC card (30) comprising:
- a plastic support (1) with a recess (6),
- an integrated circuit chip (3) hosted in said recess (6),
- a plated module (20) for covering said integrated circuit chip (3), including a printed circuit (2) comprising a plurality of conductive areas (a₁,..,aₙ), delimited by a network of insulating channels (ch₁,..,chₖ), some of said, conductive areas (a₁,..,aₙ) being connected to a corresponding contact point (c₁,..,cⱼ) of said integrated circuit chip (3), and a plurality of extended areas (ea₁,..,eaₘ) linked to a corresponding of said conductive areas (a₁,..,aₙ) by one or more bridges (br₁,.., br₁) **characterised by** comprising advanced extended areas which wrap around those extended areas (ea₁,..,eaₘ) which are linked to said conductive areas (a₁,aₙ) which are connected to said contact points (c₁,..,cₖ), whereby a couple of advanced extended areas form a rounded border of said plated module (20) and said advanced extended areas are linked to conductive areas (na₁,naₙ) which are not connected to contact points (c₁,..,cₖ).

2. IC card (30) according to claim 1 **characterised by** the fact that said advanced extended areas form the opposite rounded sides of said plated module (20).

3. IC card. (30) according to claim 1 **characterised by** the fact that said conductive areas (a₁,..,aₙ) which are linked to said contact points (c₁,..,cₖ) are separated from said extended areas (ea₁,..,eaₘ) by an insulating channel (b₁, b₂), crossed by said bridges (br₁,.., bₙ).

4. IC card (30) according to claim 1 **characterised by** the fact that said insulating channels (ch₁,..,chₖ) surround said conductive areas (a₁,..,aₙ) which are linked to said contact points (c₁,..,cₖ) as a protection frame for said contact points (c₁,..,cₖ).

5. IC card (30) according to claim 1 **characterised by** the fact that at least a major side of at least one of said conductive areas (a₁, aₙ) is curved.

6. IC card (30) according to claim 1 **characterised by** the fact that at least one central conductive area (a_{c}) of said conductive areas (a₁,..,aₙ) which are connected to said contact points (c₁,..,cₖ) has a semi-circumferential side.

7. IC card (30) comprising according to claim 1 **characterised by** the fact that said extended areas (ea₁,..,eaₘ) and/or said bridges (br₁,.., bn) are conductive.

8. IC card (30) according to claim 1 **characterised by** the fact that said extended areas (ea₁,..,eaₘ) and/or said bridges (br₁,.., bₙ) are in insulating material.

9. IC Card according to claim 1 **characterised by** the fact that said recess (6) is decentered respect a major axis (x) and/or a minor axis (y) of a major surface of said plastic support (1).

10. IC Card according to any one of the previous claims **characterised by** comprising an antenna (5) laying inside said plastic support (1) and connected to said contact points (c1, cj) through a couple of pads (p1, p2).

11. IC Card according to claim 10 **characterised by** the fact that a plurality of additional pads (p₃, p₄) are used to connect said antenna (5) and said contact points (c₁,..,cⱼ) in order to supply power from the antenna (5) to the contact points (c₁,..,cⱼ) also if said pads (p₁, p₂) are broken.

12. IC Card according to claim 11 **characterised by** the fact that a plurality of insulating channels (r1, r2) wrap around said pads (p1, p2, p3, p4).

## Patentansprüche

1. IC-Karte (30), aufweisend:
- einen Kunststoffträger (1) mit einer Ausnehmung (6),
- einen Chip mit integrierter Schaltung (3), der in der Ausnehmung (6) untergebracht ist,
- ein plattiertes Modul (20) zum Abdecken des Chips mit integrierter Schaltung (3), das eine gedruckte Schaltung (2) umfasst, aufweisend eine Mehrzahl von leitfähigen Bereichen (a₁,...,aₙ), die durch ein Netzwerk von isolierenden Kanälen (ch₁,...,chₖ) begrenzt sind, wobei einige der leitfähigen Bereiche (a₁,...,aₙ) mit einem entsprechenden Kontaktpunkt (c₁,...,cⱼ) des Chips mit integrierter Schaltung (3) verbunden sind, und eine Mehrzahl von erweiterten Bereichen (ea₁,...,eaₘ), die über eine oder mehrere Brücken (br₁,...,brₗ) mit einem entsprechenden der leitfähigen Bereiche (a₁,...,aₙ) verbunden sind, **gekennzeichnet durch** das Aufweisen weitergehender erweiterter Bereiche, die die erweiterten Bereiche (ea₁...,eaₘ) umgeben, die mit den leitfähigen Bereichen (a₁,aₙ) verbunden sind, die mit den Kontaktpunkten (c₁,...,cₖ) verbunden sind, wobei
ein Paar weitergehender erweiterter Bereiche einen gerundeten Rand des plattierten Moduls (20) bildet, und
die weitergehenden erweiterten Bereiche mit leitfähigen Bereichen (na₁,naₙ) verbunden sind, die nicht mit Kontaktpunkten (c₁,...,cₖ) verbunden sind.

2. IC-Karte (30) nach Anspruch 1, **gekennzeichnet durch** die Tatsache, dass die weitergehenden erweiterten Bereiche die gegenüberliegenden gerundeten Seiten des plattierten Moduls (20) bilden.

3. IC-Karte (30) nach Anspruch 1, **gekennzeichnet durch** die Tatsache, dass die mit den Kontaktpunkten (c₁,...,cₖ) verbundenen leitfähigen Bereiche (a₁,...,aₙ) von den erweiterten Bereichen (ea₁,...,eaₘ) **durch** einen isolierenden Kanal (b₁, b₂) getrennt sind, der von den Brücken (br₁,...,brᵢ) überquert wird.

4. IC-Karte (30) nach Anspruch 1, **gekennzeichnet durch** die Tatsache, dass die isolierenden Kanäle (ch₁,...,chₖ) die mit den Kontaktpunkten (c₁,...,cₖ) verbundenen leitfähigen Bereiche (a₁, aₙ) als ein Schutzrahmen für die Kontaktpunkte (c₁,...,cₖ) umgeben.

5. IC-Karte (30) nach Anspruch 1, **gekennzeichnet durch** die Tatsache, dass mindestens eine Hauptseite mindestens eines der leitfähigen Bereiche (a₁,aₙ) kurvenförmig ist.

6. IC-Karte (30) nach Anspruch 1, **gekennzeichnet durch** die Tatsache, dass mindestens ein in der Mitte gelegener leitfähiger Bereich (a_{c}) der mit den Kontaktpunkten (c₁...,cₖ) verbundenen leitfähigen Bereiche (a₁,...,aₙ) eine halbkreisförmige Seite hat.

7. IC-Karte (30) nach Anspruch 1, **gekennzeichnet durch** die Tatsache, dass die erweiterten Bereiche (ea₁,...,eaₙ) und/oder die Brücken (br₁,,...,brₗ) leitfähig sind.

8. IC-Karte (30) nach Anspruch 1, **gekennzeichnet durch** die Tatsache, dass die erweiterten Bereiche (ea₁,...,eaₘ) und/oder die Brücken (br₁,...,brₗ) in isolierendem Material sind.

9. IC-Karte nach Anspruch 1, **gekennzeichnet durch** die Tatsache, dass die Ausnehmung (6) bezüglich einer Hauptachse (x) und/oder einer Nebenachse (y) einer Hauptoberfläche des Kunststoffträgers (1) dezentriert ist.

10. IC-Karte nach einem der vorhergehenden Ansprüche, **dadurch gekennzeichnet, dass** sie eine Antenne (5) aufweist, die innerhalb des Kunststoffträgers (1) liegt und über ein Paar Kontaktierungsflächen (p1, p2) mit den Kontaktpunkten (c₁,...,cⱼ) verbunden ist.

11. IC-Karte nach Anspruch 10, **gekennzeichnet durch** die Tatsache, dass eine Mehrzahl von zusätzlichen Kontaktierungsflächen (p₃, p₄) für die Verbindung der Antenne (5) mit den Kontaktpunkten (c₁,...,cⱼ) verwendet wird, um den Kontaktpunkten (c₁,...,cⱼ) Energie von der Antenne (5) auch dann zuzuführen, wenn die Kontaktierungsflächen (p₁, p₂) kaputt sind.

12. IC-Karte nach Anspruch 11, **gekennzeichnet durch** die Tatsache, dass die Kontaktierungsflächen (p1, p2, p3, p4) eine Mehrzahl von isolierenden Kanälen (r1, r2) umgibt.

## Revendications

1. Carte de circuit intégré (30), comprenant :
- un support en plastique (1) avec un évidement (6),
- une puce de circuit intégré (3) logée dans ledit évidement (6),
- un module métallisé (20) destiné à recouvrir ladite puce de circuit intégré (3) et comportant un circuit imprimé (2) avec plusieurs zones conductrices (a₁,..,aₙ) délimitées par un réseau de canaux isolants (ch₁,..,chₖ), certaines desdites zones conductrices (a₁,..,aₙ) étant connectées à un point de contact (c₁,..,cⱼ) correspondant de ladite puce de circuit intégré (3), et plusieurs zones étendues (ea₁,..,eaₘ) reliées à une zone correspondante desdites zones conductrices (a₁,..,aₙ) par un ou plusieurs ponts (br₁,..,brᵢ), **caractérisée par le fait qu'**elle comprend des zones étendues perfectionnées qui entourent les zones étendues (ea₁,..,eaₘ) qui sont reliées auxdites zones conductrices (a₁, aₙ) connectées auxdits points de contact (c₁,..,cₖ), grâce à quoi deux zones étendues perfectionnées forment un bord arrondi dudit module métallisé (20) et lesdites zones étendues perfectionnées sont reliées à des zones conductrices (na₁,naₙ) qui ne sont pas connectées à des points de contact (c₁,..,cₖ).

2. Carte de circuit intégré (30) selon la revendication 1, **caractérisée par le fait que** lesdites zones étendues perfectionnées forment les côtés arrondis opposés dudit module métallisé (20).

3. Carte de circuit intégré (30) selon la revendication 1, **caractérisée par le fait que** lesdites zones conductrices (a₁..,aₙ), qui sont reliées auxdits points de contact (c₁,..,cₖ), sont séparées desdites zones étendues (ea₁,..,eaₙ) par un canal isolant (b₁,b₂) traversé par lesdits ponts (br₁,..,brᵢ).

4. Carte de circuit intégré (30) selon la revendication 1, **caractérisée par le fait que** lesdits canaux isolants (ch₁,..,chₖ) entourent lesdites zones conductrices (a₁,..aₙ) qui sont reliées auxdits points de contact (c₁,..,cₖ) en tant que cadre de protection pour lesdits points de contact (c₁,..,cₖ).

5. Carte de circuit intégré (30) selon la revendication 1, **caractérisée par le fait qu'**au moins un grand côté d'au moins une desdites zones conductrices (a₁,aₙ) est incurvé.

6. Carte de circuit intégré (30) selon la revendication 1, **caractérisée par le fait qu'**au moins une zone conductrice centrale (a_{c}) desdites zones conductrices (a₁,..,aₙ) qui sont connectées auxdits points de contact (c₁,..,cₖ) a un côté semi-circonférentiel.

7. Carte de circuit intégré (30) selon la revendication 1, **caractérisée par le fait que** lesdites zones étendues (eaᵢ,..,eaₘ) et/ou lesdits ponts (br₁,..,brᵢ) sont conducteurs.

8. Carte de circuit intégré (30) selon la revendication 1, **caractérisée par le fait que** lesdites zones étendues (eaᵢ,..,eaₘ) et/ou lesdits ponts (br₁,..,brᵢ) sont faits d'un matériau isolant.

9. Carte de circuit intégré selon la revendication 1, **caractérisée par le fait que** ledit évidement (6) est excentré par rapport à un axe principal (x) et/ou un second axe (y) d'une surface principale dudit support en plastique (1).

10. Carte de circuit intégré selon l'une quelconque des revendications précédentes, **caractérisée par le fait qu'**elle comprend une antenne (5) placée à l'intérieur dudit support en plastique (1) et connectée auxdits points de contact (c₁,..,cⱼ) par deux plots (p₁,p₂).

11. Carte de circuit intégré selon la revendication 10, **caractérisée par le fait que** plusieurs plots supplémentaires (p₃, p₄) sont utilisés pour connecter ladite antenne (5) et lesdits points de contact (c₁,..,cⱼ), en vue de l'alimentation électrique depuis l'antenne (5) aux points de contact (c₁,..,cⱼ), même lorsque lesdits plots (p₁,p₂) sont brisés.

12. Carte de circuit intégré selon la revendication 11, **caractérisée par le fait que** plusieurs canaux isolants (r₁,..,r₂) sont disposés autour desdits plots (p1, p2, p3, p4)
